# DEMANDE DE BREVET EUROPEEN

(11) **EP 2 605 406 A1**
(43) Date de publication de la demande: **19.06.2013**
(21) Numéro de dépôt: 11194002.9
(22) Date de dépôt: 16.12.2011
(51) Int. Cl.: H03K 7/08, H03K 5/13

(54) **Générateur de signal à largeur d'impulsion variable**

(71) Demandeur: EM Microelectronic-Marin SA, 2074 Marin (CH)
(72) Inventeur: Plavec, Lubomir, 262 13 Necin (CZ); Théoduloz, Yves, 1400 Yverdon (CH); Drechsler, Petr, 252 42 Jesenice (CZ)
(74) Mandataire: Ravenel, Thierry Gérard Louis

(57) **Abrégé**

La présente invention concerne un circuit générateur de signal (1) alimenté par une tension d'alimentation et comprenant des moyens de basculement (2) comprenant une première entrée à laquelle est connecté un signal d'entrée continu (E1) dont l'amplitude est défini, une deuxième entrée à laquelle est connecté un signal d'horloge (Sclk) dont le rapport cyclique est défini et une troisième entrée pour la remise à zéro, et fournissant en sortie, un signal de sortie (Sout) dont le rapport cyclique est celui du signal d'horloge et dont l'amplitude est celle du signal d'entrée, caractérisée en ce que ledit circuit comprend en outre des moyens de régulations (3) agencés pour comparer le signal de sortie avec un signal de consigne (E3) représentatif du rapport cyclique désiré et pour fournir un signal de commande (S4) connecté à la troisième entrée des moyens de basculement de sorte à activer la remise à zéro pour modifier le rapport cyclique du signal de sortie.

## Description

La présente invention concerne un circuit générateur de signal alimenté par une tension d'alimentation et comprenant des moyens de basculement comprenant une première entrée à laquelle est connecté un signal d'entrée continu dont l'amplitude est défini, une deuxième entrée à laquelle est connecté un signal d'horloge dont le rapport cyclique est défini et une troisième entrée pour la remise à zéro, et fournissant en sortie, un signal de sortie dont le rapport cyclique est celui du signal d'horloge et dont l'amplitude est celle du signal d'entrée.

### ARRIERE PLAN TECHNOLOGIQUE

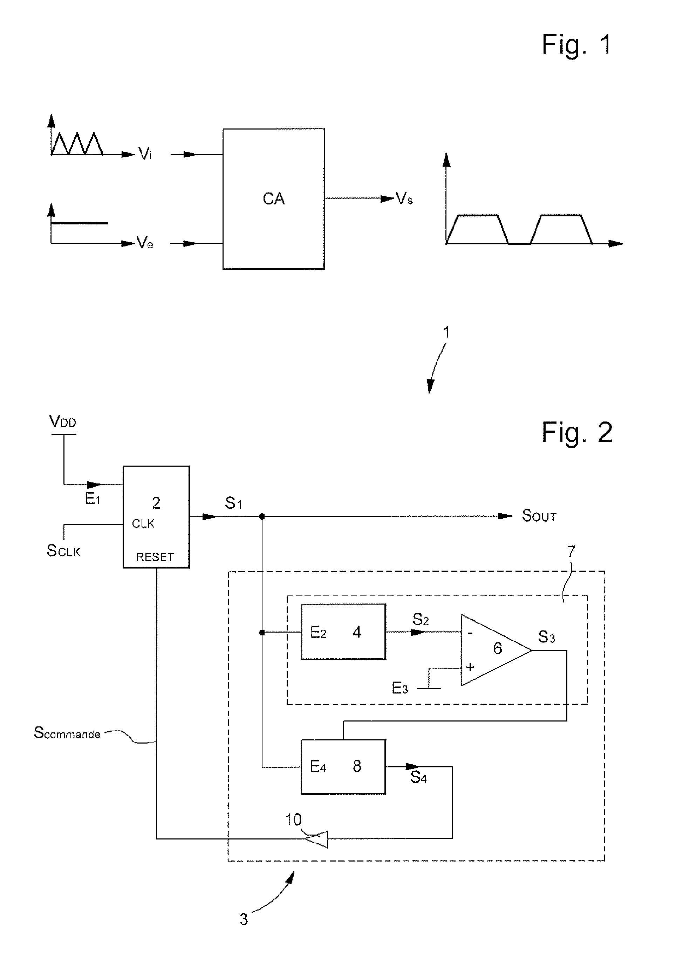

Il est connu des générateurs de signaux comprenant un comparateur analogique CA auquel il est connecté un signal triangulaire Vi et un signal d'entrée Ve continu ayant comme amplitude une tension de référence comme visible à la figure 1. Lors du fonctionnement du comparateur CA, le signal d'entrée et le signal triangulaire sont comparés pour fournir un signal de sortie. Celle-ci se présente sous la forme d'un signal rectangulaire. En effet, le signal de sortie Vs est un signal continu qui commute lorsque la tension du signal triangulaire atteint la valeur de tension du signal d'entrée. De ce fait, le signal de sortie présente une forme régulière de créneaux. Ce signal en créneau présent alors une largeur d'impulsion, c'est-à-dire un rapport entre l'état haut ou l'état bas du signal et la période. Ce ratio correspond, dans le cas du montage décrit, au rapport entre la tension de référence et l'amplitude du signal triangulaire.

Un inconvénient de ce montage est qu'il nécessite que le comparateur CA soit rapide car ce dernier doit commuter à chaque intervalle de temps et que la commutation doit être rapide sous peine d'affecté le signal de sortie.

Par ailleurs, le réglage du rapport cyclique α se fait en modifiant la valeur de la tension de référence. Or, l'amplitude du signal triangulaire doit être liée à la valeur de tension du signal de référence. Si tel n'est pas le cas, alors une erreur intervient au niveau du rapport cyclique et ce dernier n'est pas celui souhaité.

Il est également connu d'utiliser une horloge ayant une fréquence N fois supérieure à la fréquence désirée pour le signal de sortie. Ce rapport de N est le nombre d'échelon discret du changement de rapport cyclique. Pour cela, on utilise généralement un compteur synchrone à haute fréquence et un comparateur numérique à la sortie du compteur. Le rapport cyclique souhaité est la valeur de comparaison du comparateur.

Néanmoins, cette technique est gourmande en énergie notamment si la fréquence augmente et si la résolution, c'est-à-dire le nombre d'échelon augmente.

### RESUME DE L'INVENTION

L'invention concerne un générateur de signal à modulation de largeur d'impulsion qui est simple, fiable, peu gourmand en énergie.

A cet effet, l'invention concerne un circuit générateur de signal alimenté par une tension d'alimentation et comprenant des moyens de basculement comprenant une première entrée à laquelle est connecté un signal d'entrée continu dont le niveau de tension est défini, une deuxième entrée à laquelle est connecté un signal d'horloge dont la fréquence et le rapport cyclique sont définis et une troisième entrée pour la remise à zéro, et fournissant en sortie, un signal de sortie dont la fréquence est celle du signal d'horloge et dont l'amplitude est celle du signal d'entrée, caractérisée en ce que ledit circuit comprend en outre des moyens de régulation agencés pour comparer le signal de sortie avec un signal de consigne représentatif du rapport cyclique désiré et pour fournir un signal de commande connecté à la troisième entrée des moyens de basculement de sorte à activer la remise à zéro pour modifier le rapport cyclique du signal de sortie. Un premier avantage de la présente invention est qu'elle permet un réglage simple du rapport cyclique. En effet, seul le signal de consigne est modifié c'est-à-dire que seul le niveau de tension du signal de consigne est augmenté ou abaissé pour modifier le rapport cyclique. Il est donc facile de fournir un signal continu dont l'amplitude peut être variée contrairement à un signal triangulaire plus difficile à générer.

Un second avantage est que le générateur selon la présente invention est peu gourmand en énergie par rapport au générateur selon l'art antérieur car il n'utilise pas de composants à hautes fréquences. Or, ces composants à hautes fréquences ont l'inconvénient d'être gourmands en énergie électrique. De plus, comme il n'est pas nécessaire d'avoir des composants devant commutés rapidement, les coûts sont minimisés.

Des modes de réalisation avantageux de ce capteur font l'objet des revendications dépendantes.

Dans un premier mode de réalisation avantageux, les moyens de régulation comprennent un circuit de délai connecté au signal de sortie des moyens de basculement et configuré pour fournir le signal de commande remettant à zéro le signal de sortie du circuit générateur lorsque l'état haut dudit signal de sortie atteint le rapport cyclique désiré,

Dans un second mode de réalisation avantageux, le circuit de délai comprend une première zone comprenant un premier transistor de type P ayant sa source connectée à la tension d'alimentation et son drain connecté au drain d'un premier transistor de type N , la source de ce premier transistor de type N étant connectée au drain d'un second transistor de type N ayant sa source reliée à la masse, le signal d'entrée étant relié sur la grille du premier transistor de type P et sur la grille du premier transistor de type N, cette première zone étant relié à une deuxième zone comprenant un second transistor de type P et un troisième transistor de type N, le second transistor de type P ayant sa source connectée à la tension d'alimentation et son drain connecté au drain du troisième transistor de type N qui a sa source connectée à la masse du circuit, les grilles du second transistor de type P et du troisième transistor de type N sont toutes les deux reliées au point de connexion des drains des premiers transistors de type P et de type N, la sortie du circuit de délai étant le point de connexion des drains du second transistor de type P et du troisième transistor de type N, les premières et secondes zones étant reliées par des condensateurs montés en parallèle vers la masse.

Dans un autre mode de réalisation avantageux, les moyens de régulation comprennent en outre un ensemble consigne comparant le signal de sortie des moyens de basculement à un signal de consigne représentatif du rapport cyclique désiré afin de générer un signal de réglage envoyé à la grille du second transistor de type N du circuit de délai afin de retarder ou d'avancer la remise à zéro du signal de sortie du circuit générateur en fonction du signal de consigne représentatif du rapport cyclique désiré.

Dans un autre mode de réalisation avantageux, l'ensemble consigne comprend un circuit de filtrage dont l'entrée est connecté au signal de sortie des moyens de basculement et utilisé pour moyenner ledit signal de sortie, et un circuit comparateur dont les entrées sont, la sortie du circuit de filtrage et le signal de consigne représentatif du rapport cyclique désiré, ledit circuit comparateur fournissant ledit signal de réglage dont le niveau de tension, représentatif de la différence entre la sortie du circuit de filtrage et le signal de consigne, permet de faire de modifier le courant passant dans le second transistor de type N du circuit de délai.

Dans un autre mode de réalisation avantageux, le circuit de filtrage est un filtre passe-bas.

Dans un autre mode de réalisation avantageux, les moyens de basculement sont une bascule D.

### BREVE DESCRIPTION DES FIGURES

Les buts, avantages et caractéristiques du circuit générateur de signal selon la présente invention apparaîtront plus clairement dans la description détaillée suivante d'au moins une forme de réalisation de l'invention donnée uniquement à titre d'exemple non limitatif et illustrée par les dessins annexés sur lesquels :
- la figure 1 représente de manière schématique un circuit générateur selon l'art antérieur;
- la figure 2 représente de manière schématique un schéma de principe d'un circuit générateur selon l'invention ;et

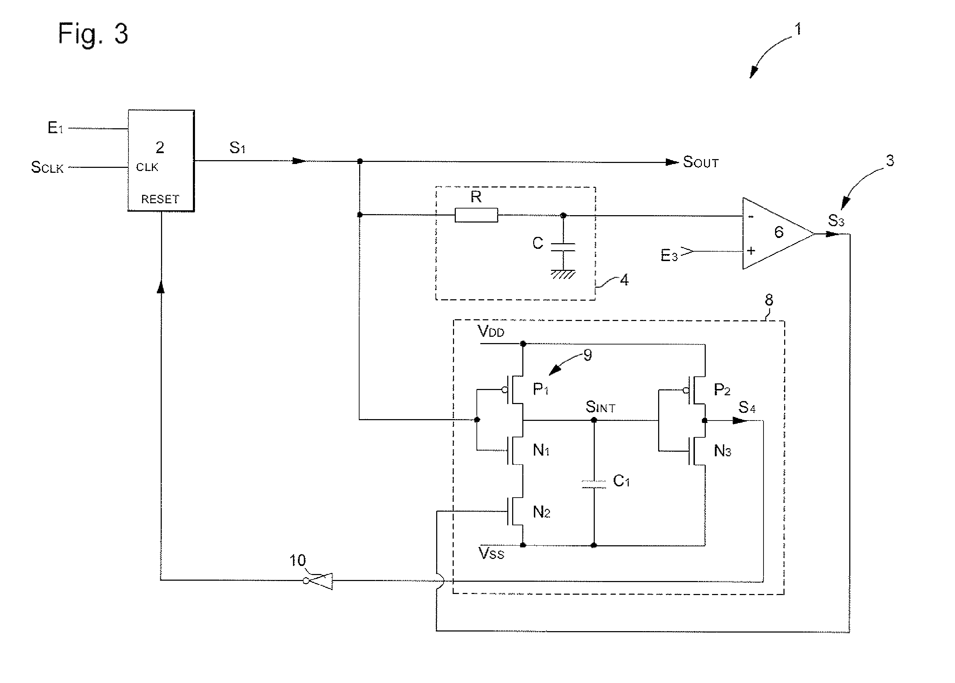

- la figure 3 représente de manière schématique le schéma électrique du circuit générateur selon l'invention.

### DESCRIPTION DETAILLEE

La figure 2 montre le générateur de signal à modulation de largeur d'impulsion 1 selon la présente invention. Ce générateur 1 comprend des moyens de basculement 2 comprenant trois entrées et une sortie. Une première entrée CLK est connectée à un signal d'horlogeScIk. Ce signal est de préférence un signal carré. La deuxième entrée est reliée à un signal d'entrée continu E1 ayant pour niveau de tension la tension d'alimentation Vdd. Ce signal d'entrée est utilisé afin de réinitialiser le signal de sortie à Vdd (niveau logique 1) au moment du flan actif du signal d'horloge CLK, cette utilisation sera expliquée ultérieurement. La troisième entrée est une entrée de remise à zéro à laquelle est relié un signal RESET de remise à zéro ou reset puisse être envoyé, ce signal défini le temps que le signal de sortie S1 passe au niveau de tension Vdd (niveau logique 1) et ainsi défini le rapport cyclique α du signal de sortie S1.

Le signal de sortie S1 des moyens de basculement 2 est aussi lieu le signal de sortie finale Sout du générateur. Cette sortie est également connectée à une boucle de régulation 3. Cette boucle de régulation 3 comprend un circuit de filtrage 4. Le signal de sortie S1 est connecté à une entrée E2 du circuit de filtrage 4, ce dernier est utilisé pour moyenner le signal S1. La sortie de ce circuit de filtrage 4 fournit un signal S2. Ce signal S2 est une tension continue valant la moyenne du signal de sortie S1 et est connecté à l'entrée négative d'un amplificateur opérationnel 6 faisant également partie de la boucle de régulation 3. L'entrée positive dudit amplificateur opérationnel 6 est connectée à un signal continu Vref dont le niveau de tension peut être défini par l'utilisateur. L'amplificateur opérationnel 6 fournit, en sortie, un signal continu S3 dont le niveau de tension est représentatif de la différence entre des deux signaux. Cette sortie de l'amplificateur 6 est connectée à un circuit de délai 8 comportant une entrée E4 à laquelle est connectée le signal de sortie S1 des moyens de basculement 2. Ce circuit de délai 8, intégré dans la boucle de régulation 3, est utilisé de sorte que le signal de sortie S4 de ce circuit de délai 8 est un signal de commande passant par un circuit inverseur 10 pour ensuite être connecté à la l'entrée RESET du moyen de basculement 2. Ce signal de sortie S4 agit donc comme signal de remise à zéro

Plus précisément, les moyens de basculement 2 sont une bascule D. cette bascule D 2 a, comme première entrée un signal d'horloge ScIk de préférence un signal carré dont le rapport cyclique α est de 50%, et comme deuxième entrée, un signal d'entrée E1 continu ayant comme niveau de tension une valeur de tension de référence. La sortie de cette bascule D 2 fournit un signal de sortie S1 carré dont le niveau de tension est celui du signal d'entrée E1. Ce signal de sortie S1 de la bascule D 2 est le signal de sortie finale Sout du générateur 1.

Avantageusement selon l'invention, ce signal de sortie finale Sout est contrôlé via des moyens de régulation 3 sous la forme d'une boucle de régulation décrite en détails ci-dessous.

Le signal S1 est envoyé un ensemble consigne 7 comprenant un circuit de filtrage 4. Ce circuit de filtrage 4 est un filtre passe bas, typiquement, un circuit RC. Un filtre passe bas du type RLC ou Sallen-Key peut aussi être envisagé. Ce circuit de filtrage 4 est utilisé afin de moyenner le signal S1. Le résultat du filtrage du signal S1, qui est un signal créneau, est un signal continu S2. Les composants de ce circuit de filtrage 4, c'est-à-dire la résistance R et le condensateur C, sont calculés pour que le niveau de tension obtenu soit proportionnel au rapport cyclique. Par exemple, pour un signal S1 de rapport cyclique de 50% et de niveau de tension Vdd, on obtiendrait un signal S2 continu dont le niveau de tension est de Vdd/2. Pareillement, pour un signal S1 de rapport cyclique de 25% et de niveau de tension Vdd, on obtiendrait un signal S2 continu dont le niveau de tension est de Vdd/4.

Ce signal S2 est ensuite connecté à l'entrée négative de l'amplificateur opérationnel 6 faisant également partie de l'ensemble consigne 7. A l'entrée positive de cet amplificateur opérationnel 6, est connecté à un signal E3. Ce signal E3 est un signal continu de niveau de tension Vref. Le signal S2 et le signal E3 sont comparés l'un par rapport à l'autre pour fournir en sortie dudit amplificateur opérationnel 6 un signal S3 appelé signal de consigne. Ce signal de consigne S3 est connecté à une des entrées du circuit de délai 8. Ce dernier a également comme entrée le signal S1 sortant des moyens de basculement 2.

Le circuit de délai 8 comprend deux zones distinctes. Une première zone comprend trois moyens de commutation 9, ici des transistors MOSFET. Plus particulièrement, ces trois moyens de commutation 9 sont deux transistors N1 et N2 de type N et un transistor P1 de type P. Ces trois transistors sont montés de sorte que le premier transistor P1 de type P à sa source connectée à la tension d'alimentation Vdd et son drain connecté au drain d'un premier transistor N1 de type N. La source de ce premier transistor N1 de type N est connectée au drain d'un second transistor N2 de type N. Ce dernier voit sa source reliée à la masse Vss du circuit de délai 8. Le signal S1 est relié en même temps sur la grille du premier transistor P1 de type P et sur la grille du premier transistor N1 de type N, la grille du second transistor N2 de type N étant relié au signal S3.

Le point de connexion entre le premier transistor P1 de type P et le premier transistor N1 de type N est utilisé pour relier cette première zone du circuit de délai à la seconde zone du circuit de délai. Cette seconde zone comprend deux moyens de commutation 9 se présentant sous la forme de deux transistors : un second transistor P2 de type P et un troisième transistor N3 de type N. Le second transistor P2 de type P a sa source connectée à la tension d'alimentation Vdd et son drain connecté à la source du troisième transistor N3 de type N. Ce dernier a son drain connecté à la masse Vss du circuit 8. Les grilles des transistors P2 et N3 sont toutes les deux reliées au point de connexion entre les transistors P1 et N1.

Entre ces deux zones, au moins un condensateur de découplage C1 est agencé en parallèle de sorte que l'entrée du condensateur C1 est reliée au point de connexion entre les transistors P1 et N1 et aux grilles des transistors P2 et N3 alors que la sortie du condensateur C1 est connectée à la masse Vss. Bien entendu, il est envisageable d'avoir plusieurs condensateurs montés en parallèle pour

La sortie du circuit de délai 8 est le point de connexion entre les transistors P2 et N3. Le signal en sortie du circuit de délai 8 est le signal de commande S4 qui est ensuite inversé par un circuit inverseur 10. Une fois ce signal de consigne S4 inversé, il est connecté à l'entrée RESET de la bascule D 2. Cette connexion permet au signal de commande S4 d'agir directement sur le signal S1 pour le modifier.

Lors du fonctionnement de ce générateur de signal 1, le rapport cyclique du signal de sortie S1, Sout est modifié et régulé par la boucle de régulation 3. Cette boucle de régulation 3 comprend le circuit de délai 8, le circuit de filtrage 4 et l'amplificateur opérationnel 6.

En effet, le circuit de filtrage 4 et l'amplificateur opérationnel 6, formant l'ensemble consigne 7, sont utilisés pour comparer le niveau de tension du signal S2, proportionnel à la tension d'alimentation Vdd et représentatif du rapport cyclique α du signal S1, avec le signal E3 de niveau de tension Vref et fournir un signal commandant le circuit de délai 8. Le circuit de délai 8 fonctionne comme expliqué si dessous.

Le signal S1 est appliqué à l'entrée E4 du circuit de délai 8 c'est-à-dire appliqué aux grilles des transistors N1 et P1.

Au démarrage, le signal S1, qui est un signal en créneau, est à l'état bas ou niveau logique 0, c'est-à-dire avec un niveau de tension de zéro Volt. Le premier transistor N1 de type N est à l'état bloqué c'est-à-dire non passant alors que le premier transistor P1 de type P est à l'état passant. La tension d'alimentation Vdd passe par le premier transistor P1 de type P et est transmise à la seconde zone. Ce signal est appelé signal intermédiaire Sint. Ce signal Sint, d'état logique 1, est appliqué aux grilles des transistors P2 et N3. Dans ce cas, le second transistor P2 de type P est à l'état non passant et le troisième transistor N3 de type N est à l'état passant. En conséquence, c'est la masse Vss, c'est-à-dire le point zéro volt ou l'état logique 0, qui est relié à la sortie faisant passer le signal de commande S4 du circuit de délai 8 à l'état bas. En passant par l'inverseur 10, ce signal de commande S4 est inversé et passe à l'état haut avant d'être envoyé sur l'entrée RESET de la bascule D 2. Or, cette bascule D 2 est configurée pour que la fonction RESET soit active à l'état bas c'est-à-dire lorsqu'un signal à l'état bas est envoyé sur l'entrée RESET du moyen de basculement 2. Comme le signal S4 inversé est à l'état haut, la fonction de remise à zéro n'est pas activée.

Lorsque le signal S1 passe à l'état haut, le transistor P1 cesse d'être passant et passe à l'état bloqué alors qu'au contraire, le transistor N1 passe de l'état bloqué à l'état passant. En supposant que le transistor N2 est également passant, le rôle de ce transistor N2 sera expliqué ultérieurement, c'est le potentiel de la masse Vss c'est-à-dire l'état logique 0, qui est transmise à la seconde zone du circuit de délai 8. Or, le condensateur C1 de découplage est utilisé pour que le passage de l'état haut à l'état bas se fasse progressivement, c'est-à-dire avec une constante de temps.

Tant que le signal Sint n'a pas franchi le seuil de tension de commutation des transistors N3 et P2, le transistor P2 reste bloqué et le transistor N3 reste passant, le signal de commande S4 ne change donc pas. Mais, lorsque le niveau de tension du signal Sint descend sous le seuil de tension de commutation des transistors N3 et P2, la commutation des transistors P2 et N3 s'opère. Le transistor P2 passe de l'état bloqué à l'état passant et le transistor N3 passe de l'état passant à l'état bloqué. Le signal de commande S4 passe ainsi de l'état bas à l'état haut. Par action de l'inverseur 10, le signal envoyé sur l'entrée RESET du moyen de basculement 2 est un signal à l'état bas. Cet état bas active la fonction de remise à zéro de la bascule 2 de sorte que le signal S1 bascule instantanément de l'état haut à l'état bas.

La conséquence est une commutation rapide du transistor P1 qui redevient passant de sorte que le signal Sint repasse à l'état haut. Lorsque le niveau de tension du signal Sint dépasse le seuil de tension des transistors P2 et N3, ces derniers commutent de sorte que le transistor P2 devienne bloqué et le transistor N3 devienne passant. Le signal de commande S4 passe alors à l'état bas et en étant inversé il passe à l'état haut lorsqu'il entre à l'entrée RESET de la bascule D 2. Cet état haut du signal appliqué à l'entrée RESET de la bascule D 2 a pour conséquence un arrêt de la fonction de remise à zéro.

Lors du fonctionnement de ce générateur 1, le réglage du rapport cyclique α est réalisé par le signal S3. Effectivement, ce signal S3 correspond à la comparaison du signal S2, qui est le signal S1 filtré, avec le signal E3 qui est un signal de référence dont le niveau de tension est une tension de référence proportionnelle à la tension d'alimentation, comme le signal S2 d'ailleurs.

L'amplificateur opérationnel est conçu pour fournir, en sortie, le signal S3 dont le niveau de tension est une tension représentative de la comparaison entre le signal S2 et le signal E3. Le niveau de tension du signal S3 augmente si le signal S2 est supérieur au signal E3 mais elle diminue si le signal S2 est inférieur au signal E3. Ce signal S3 est ensuite envoyé à la grille du transistor N2 afin de régler le rapport cyclique α.

En effet, le principe utilisé est que la comparaison entre le signal S2 et le signal E3 permet de fournir, en sortie de l'amplificateur opérationnel 6, un signal représentatif de cette comparaison agissant sur le second transistor N2 de type N. Le signal S3 est utilisé pour agir sur le canal du second transistor N2 de type N de sorte que ce canal s'ouvre plus ou moins selon le niveau de tension du signal S3, c'est-à-dire selon le résultat de la comparaison entre le signal S2 et le signal E3. Si le signal S2 est supérieur au signal E3, le niveau de tension du signal S3 augmente et, par conséquent, le transistor N2 voit son canal s'ouvrir de façon plus importante. Cela permet de faire passer un courant plus important. Or, cette ouverture plus importante du canal est perceptible lorsque le premier transistor N1 de type N est également passant c'est-à-dire lorsque le signal S1 passe à l'état haut. Cette arrivée de courant supplémentaire a une influence sur le signal Sint puisqu'en faisant passer plus de courant, la décharge du condensateur C1 est modifiée. Plus précisément, si plus de courant passe dans le second transistor N2 de type N, la décharge du condensateur C1 est plus rapide. Le signal Sint franchi donc le seuil de tension des transistors P2 et N3 plus rapidement. Comme le seuil de tension est franchi plus rapidement, les transistors P2 et N3 commutent eux aussi plus rapidement et la fonction de remise à zéro est activée plus rapidement. Cette activation plus rapide a pour effet de diminuer le rapport cyclique α du signal de sortie Sout. Ce résultat est le but recherché car si le signal S2 est supérieur au signal E3, c'est que le rapport cyclique α du signal S1 est plus important que le rapport cyclique demandé.

Au contraire, si le rapport cyclique doit être augmenté, le signal S2 est inférieur au signal E3. Le signal de sortie S3 de l'amplificateur opérationnel 6 aura un niveau de tension représentatif de cette comparaison plus faible. Ce niveau de tension plus faible a pour conséquence, une ouverture plus faible du canal du transistor N2 et donc une quantité de courant moins importante traversant ledit transistor N2. La décharge du condensateur C1 est ralentie. Le signal Sint franchi donc le seuil de tension de commutation des transistors P2 et N3 plus lentement. Comme le seuil de tension de commutation est franchi plus lentement, les transistors P2 et N3 commutent eux aussi plus lentement et la fonction de remise à zéro est activée plus lentement. Cette activation plus lente a pour effet d'augmenter le rapport cyclique α c'est-à-dire d'augmenter l'état haut du signal S1 par rapport à l'état bas. C'est le but recherché car si le signal S2 est inférieur au signal E3, c'est que le rapport cyclique α du signal S1 est moins important que le rapport cyclique α demandé.

Cette comparaison du signal S2 et du signal E3 est continue de sorte que le but de cette boucle de régulation est que le signal S2 et le signal E3 soient identiques afin de fournir un signal S3 figeant l'ouverture du canal du second transistor N2 de type N.

On conclut donc que le circuit de délai 8 est utilisé pour fournir, à un moment précis, un signal de commande S4 activant la remise à zéro. L'ensemble comprenant le circuit de filtrage 4 et l'amplificateur opérationnel 6 est agencé pour fournir un signal de consigne S3 qui modifie le moment précis ou le circuit de délai 8 envois le signal de commande S4 activant la remise à zéro. Le moment auquel le signal de commande doit remettre à zéro la bascule D 2 permet de définir le rapport cyclique α et est réglable selon la différence signal S2 et du signal E3.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

On pourra par exemple prévoir que les transistors du circuit de délai 8 sont des transistors de type bipolaire ou JFET.

## Revendications

1. Circuit générateur de signal (1) alimenté par une tension d'alimentation et comprenant des moyens de basculement (2) comprenant une première entrée à laquelle est connecté un signal d'entrée continu (E1) dont le niveau de tension est défini, une deuxième entrée à laquelle est connecté un signal d'horloge (ScIk) dont la fréquence et le rapport cyclique sont définis et une troisième entrée pour la remise à zéro, et fournissant en sortie, un signal de sortie (S1, Sout) dont la fréquence est celle du signal d'horloge et dont l'amplitude est celle du signal d'entrée, **caractérisée en ce que** ledit circuit (1) comprend en outre des moyens de régulation (3) agencés pour comparer le signal de sortie avec un signal de consigne (E3) représentatif du rapport cyclique désiré et pour fournir un signal de commande (S4) connecté à la troisième entrée des moyens de basculement de sorte à activer la remise à zéro pour modifier le rapport cyclique du signal de sortie (S1).

2. Circuit générateur de signal selon la revendication 1, **caractérisé en ce que** les moyens de régulation (3) comprennent un circuit de délai (8) connecté au signal de sortie (S1) des moyens de basculement (2) et configuré pour fournir le signal de commande (S4) remettant à zéro le signal de sortie (S1, Sout) du circuit générateur lorsque l'état haut dudit signal de sortie (S1, Sout) atteint le rapport cyclique désiré,

3. Circuit générateur de signal selon la revendication 2, caractérisé ce que le circuit de délai (8) comprend une première zone comprenant un premier transistor de type P (P1) ayant sa source connectée à la tension d'alimentation (Vdd) et son drain connecté au drain d'un premier transistor de type N (N1), la source de ce premier transistor de type N étant connectée au drain d'un second transistor de type N (N2) ayant sa source reliée à la masse, le signal de sortie (S1) étant relié sur la grille du premier transistor de type P et sur la grille du premier transistor de type N, cette première zone étant relié à une deuxième zone comprenant un second transistor de type P et un troisième transistor de type N, le second transistor de type P ayant sa source connectée à la tension d'alimentation (Vdd) et son drain connecté au drain du troisième transistor de type N qui a sa source connectée à la masse (Vss) du circuit, les grilles du second transistor de type P et du troisième transistor de type N sont toutes les deux reliées au point de connexion des drains des premiers transistors de type P et de type N, la sortie du circuit de délai (S4) étant le point de connexion des drains du second transistor de type P et du troisième transistor de type N, les premières et secondes zones étant reliées par un condensateur (C1) montés en parallèle.

4. Circuit générateur de signal selon les revendications 2 ou 3, **caractérisé en ce que** les moyens de régulation (3) comprennent en outre un ensemble consigne (7) comparant le signal de sortie (S1) des moyens de basculement (2) à un signal de consigne représentatif du rapport cyclique désiré (E3) afin de générer un signal de réglage (S3) envoyé à la grille du second transistor de type N (N2) du circuit de délai (8) afin de retarder ou d'avancer la remise à zéro du signal de sortie (S1) du circuit générateur (1) en fonction du signal de consigne représentatif du rapport cyclique désiré (E3).

5. Circuit générateur de signal selon la revendication 4 selon 3, **caractérisé en ce que** l'ensemble consigne (7) comprend un circuit de filtrage (4) dont l'entrée est connecté au signal de sortie (S1) des moyens de basculement (2) et utilisé pour moyenner ledit signal de sortie, et un circuit comparateur (6) dont les entrées sont, la sortie du circuit de filtrage (4) et le signal de consigne représentatif du rapport cyclique désiré (E3), ledit circuit comparateur (6) fournissant ledit signal de réglage (S3) dont le niveau de tension, représentatif de la différence entre la sortie du circuit de filtrage et le signal de consigne (E3), permet de faire de modifier le courant passant dans le second transistor de type N (N2) du circuit de délai (8).

6. Circuit générateur de signal selon la revendication 5, caractérisé ce que le circuit de filtrage (4) est un filtre passe-bas.

7. Circuit générateur de signal selon la revendication 1, caractérisé ce que les moyens de basculement (2) sont une bascule D.
